# EUROPÄISCHE PATENTANMELDUNG

(11) **EP 2 747 287 A1**
(43) Veröffentlichungstag der Anmeldung: **25.06.2014**
(21) Anmeldenummer: 12197859.7
(22) Anmeldetag: 18.12.2012
(51) Int. Cl.: H03K 17/94

(54) **Schaltungsanordnung zum Bremsen einer sich bewegenden Masse beim Abschalten eines elektromechanischen Schaltgeräts mit einer induktiven Last**

(71) Anmelder: Siemens Aktiengesellschaft, 80333 München (DE)
(72) Erfinder: Danzer, Klaus, 93449 Waldmünchen (DE); Oppermann, Christian, 92224 Amberg (DE); Streich, Bernhard, 92224 Amberg (DE); Werner, Roland, 92224 Amberg (DE); Zimmermann, Norbert, 92237 Sulzbach-Rosenberg (DE)

(57) **Zusammenfassung**

Es wird eine Schaltungsanordnung zum Bremsen einer bewegenden Masse beim Abschalten eines elektromechanischen Schaltgeräts mit einer induktiven Last (1) vorgeschlagen. Die Schaltungsanordnung umfasst einen Freilaufkreis, der eine parallel zur Last (1) liegende Reihenschaltung aus einer ersten Diode (5) und einem Begrenzungselement (7) umfasst, wobei dem Begrenzungselement (7) ein erstes Schaltelement (6) parallel geschaltet ist, ferner ein zweites Schaltelement (9), das zum Ein- und Ausschalten der Last (1) in Reihe mit dem Freilaufkreis verschaltet ist, und eine Ansteuerung. Die Ansteuerung umfasst eine Auswerte- und Steuereinheit (10) zur synchronen Ansteuerung des ersten und zweiten Schaltelements (6, 9), wobei die Auswerte- und Steuereinheit (10) zur Ansteuerung des ersten Schaltelements (6) mit einer galvanisch getrennten Ansteuerung (8) des ersten Schaltelements (6) und zur Ansteuerung des zweiten Schaltelements (9) mit dessen Steuereingang (G) verbunden ist und die Ansteuerung des ersten und des zweiten Schaltelements in Abhängigkeit der Höhe einer messtechnisch ermittelten Steuerspeisespannung erfolgt.

## Beschreibung

Die Erfindung betrifft eine Schaltungsanordnung zum Bremsen einer sich bewegenden Masse beim Abschalten eines elektromechanischen Schaltgeräts mit einer induktiven Last. Die induktive Last ist insbesondere eine Spule eines elektromechanischen Schaltgeräts. Die Schaltungsanordnung umfasst einen Freilaufkreis, der eine parallel zur Last liegende Reihenschaltung aus einer ersten Diode und einem Begrenzungselement umfasst, wobei dem Begrenzungselement ein erstes Schaltelement parallel geschaltet ist, ferner ein zweites Schaltelement, das zum Ein- und Ausschalten der Last in Reihe mit dem Freilaufkreis verschaltet ist, und eine Ansteuerung.

Elektromechanische Schaltgeräte schalten über eine Bewegung eines oder mehrerer mechanischer Schaltkontakte die Leistung für einen Verbraucher zu oder weg. Die Bewegung eines Schaltkontakts erfolgt hierbei in nur einer Raumachse. Sie wird durch einen elektromagnetischen Antrieb des Schaltgeräts gesteuert. Legt man eine Spannung an die Spule eines Elektromagneten des Antriebs, so wird ein beweglicher Anker von einem starren Joch angezogen. Durch die Bewegung des Ankers erfolgt die Bewegung des oder der daran angebrachten Kontakte. Wird die Spannung weggenommen, dann hört die magnetische Wirkung auf. Um den Anker wieder in die ursprüngliche Position zu bringen, muss eine Kraft in die entgegengesetzte Richtung wirken. Diese wird üblicherweise durch sogenannte Rückdruckfedern erreicht.

Elektromechanische Schaltgeräte werden auch als Schütze oder Netzschützschalter bezeichnet und häufig von einem Niederspannungsschaltgerät mit DC-Ansteuerung oder einer Ansteuerung über einen Gleichrichter (AC/DC) betrieben. Wird ein konventionelles DC-Schaltgerät (ohne Beschaltung, ohne Elektronik) ausgeschaltet, so entsteht an dessen Eingangsklemmen, d.h. den Klemmen der Spule, eine sehr hohe sog. Gegenspannung. Die Gegenspannung liegt an den Eingangsklemmen entgegen gesetzt zu der Spannung an, die zuvor an die Eingangsklemmen angelegt wurde. Dies geschieht aufgrund der Eigenschaft von Spulen, die einer plötzlichen Stromänderung mit einer induzierten Spannung entgegenwirken. Diese Spannung würde aber ins Netz zurückgespeist werden und könnte dann andere Geräte zerstören.

Deshalb beschaltet man den Eingang von Schaltgeräten, um die Gegenspannung zu reduzieren. Die Beschaltung besteht üblicherweise aus Dioden, Begrenzungselementen oder RC-Gliedern. Eine Beschaltung der Spule des Schützes mit einer Diode hat den Vorteil, dass die Gegenspannung maximal so hoch werden kann wie die Durchlassspannung der Diode. Der Nachteil allerdings ist, dass die Energie in der Spule des Schaltgerätes nur sehr langsam abgebaut wird und das Schaltgerät deshalb eine sehr lange Ausverzugszeit hat. Schneller wird die Energie über ein Begrenzungselement abgebaut, durch das die Gegenspannung auf den Sperrwert des Begrenzungselementes ansteigen kann. Je grösser dieser Wert ist, desto schneller wird die Energie in der Spule abgebaut und desto schneller öffnen die Kontakte des elektromagnetischen Antriebs.

Eine elektronische Ansteuerung eines elektromagnetischen Antriebs bezweckt die Einsparung von Energie. Der Strom, der zum Schließen der Kontakte benötigt wird, ist grösser als der Strom, der benötigt wird, um die Kontakte geschlossen zu halten. Man reduziert deshalb den Mittelwert der Spannung, der an der Spule anliegt. Dies erfolgt üblicherweise, indem die Spannung über der Spule getaktet wird, wobei die Pulsbreite des Taktes ausschlaggebend für den Mittelwert der Spannung ist.

Bei elektronisch gesteuerten, elektromechanischen Schaltgeräten können die Vorteile der beiden oben beschriebenen Beschaltungsarten kombiniert werden: um beim Ausschalten die Kontakte möglichst schnell öffnen zu können, setzt man ein Begrenzungselement ein. Auf der anderen Seite entzieht dieses Begrenzungselement bei jedem Takten die Energie aus der Spule, so dass eher eine Diodenbeschaltung sinnvoll ist. Aus diesem Grund wurde der gesteuerte Freilaufkreis entwickelt, der während des Betriebs das Begrenzungselement überbrückt. Beim Ausschalten wird diese Brücke entfernt, so dass die Schaltgeräte schnell ausschalten. Ein solcher gesteuerter Freilaufkreis ist z.B. aus der DE 10 2009 043 415 B3 bekannt.

Obwohl der gesteuerte Freilaufkreis der DE 10 2009 043 415 B3 bezüglich der Ausschaltgeschwindigkeit und des Energieverbrauchs Vorteile aufweist, ist dieser vor allem für kleine Schaltgeräte mit geringer zu schaltender Leistung geeignet.

Es ist Aufgabe der Erfindung, eine funktionell und/oder baulich verbesserte Schaltungsanordnung zum Ansteuern eines Schaltgeräts anzugeben. Eine weitere Aufgabe besteht darin, ein Verfahren zum Betreiben einer Schaltungsanordnung anzugeben, mit dem Schaltgeräte unabhängig von deren Größe zuverlässiger betrieben werden können.

Diese Aufgaben werden gelöst durch eine Schaltungsanordnung gemäß den Merkmalen des Patentanspruches 1 und ein Verfahren gemäß den Merkmalen des Patentanspruches 9. Vorteilhafte Ausgestaltungen ergeben sich aus den abhängigen Ansprüchen.

Es wird eine Schaltungsanordnung zum Abbauen von durch eine induktive Last verursachten Abschaltüberspannungen beim Abschalten der induktiven Last vorgeschlagen. Die induktive Last ist zweckmäßigerweise eine Spule eines elektromechanischen Schaltgeräts. Die Schaltungsanordnung umfasst einen Freilaufkreis, der eine parallel zur Last liegende Reihenschaltung aus einer ersten Diode und einem Begrenzungselement umfasst, wobei dem Begrenzungselement ein erstes Schaltelement parallel geschaltet ist. Die Schaltungsanordnung umfasst ferner ein zweites Schaltelement, das zum Ein- und Ausschalten der Last in Reihe mit dem Freilaufkreis verschaltet ist und eine Ansteuerung. Die Schaltungsanordnung zeichnet sich dadurch aus, dass die Ansteuerung eine Auswerte- und Steuereinheit zur synchronen Ansteuerung des ersten und zweiten Schaltelements umfasst, wobei die Auswerte- und Steuereinheit zur Ansteuerung des ersten Schaltelements mit einer galvanisch getrennten Ansteuerung des ersten Schaltelements und zur Ansteuerung des zweiten Schaltelements mit dessen Steuereingang verbunden ist und die Ansteuerung des ersten und des zweiten Schaltelements in Abhängigkeit der Höhe einer messtechnisch ermittelten Steuerspeisespannung erfolgt.

Die vorgeschlagene Schaltungsanordnung ermöglicht die Synchronisation des Freilaufkreises mit dem Ausschalten der Last. Hierdurch ist sichergestellt, dass eine exakte Ausschaltschwelle eingehalten werden kann. Dies hat wiederum zur Folge, dass bei Erreichen der immer gleichen Spannung abgeschaltet werden kann, was - durch die entsprechende Dimensionierung des Begrenzungselements abhängig von der Größe der induktiven Last (τ > 40 msec, berechnet aus L/R)- eine Begrenzung der Stromspitze auf einen vorgegebenen Wert ermöglicht. Hierdurch wird auch das Schalten von großen Lasten (Schaltgeräten) ermöglicht, welche eine große bewegte Masse, bestehend aus dem Anker, den Kontaktträgern und den Kontakten, umfassen.

Diesem Vorgehen liegt folgende Überlegung zugrunde: je grösser die bewegte Masse ist, umso grösser ist auch die potenzielle Energie, die in ihr steckt. Die potentielle Energie ist bei großen Schaltgeräten mit großen Massen (Anker und Kontaktträger ab einer Masse von > 300g) hoch, da die Kontaktkräfte grösser sind als bei kleinen und die Kraft der Rückdruckfeder in Abhängigkeit von der beweglichen Masse gewählt ist. Diese Energie wird freigesetzt, wenn das Schaltgerät ausschaltet. Wird die Energie aus der Spule schnell entfernt, was bei kleinen Schaltgeräten gewünscht wird, so wird bei großen Schaltgeräten die Bewegungsenergie, die durch das Federsystem entsteht, ebenfalls schlagartig freigesetzt. Da die bewegliche Masse hier allerdings größer ist, wird der Anker zwar abgebremst, wenn dieser seine Aus-Position erreicht. Er schwingt jedoch zurück, bis seine Energie komplett aufgebraucht ist. Durch das Zurückprallen kann es passieren, dass die Kontakte erneut schließen, d.h. sich kurz berühren. Dadurch kann das Schaltgerät verschweißen oder sogar zerstört werden.

Üblicherweise versucht man, die Energie aufzubrauchen, indem man mechanische Dämpfungselemente in das Schaltgerät einbaut. Diese bestehen aus Elastomeren (z.B. Gummi), die die Energie auffangen und das Zurückprallen minimieren. Der Nachteil bei diesen Dämpfungselementen ist allerdings, dass sie sich zum einen mit der Zeit deformieren und die Dämpfungswirkung sich dadurch verändert. Zum anderen können sich die Materialeigenschaften durch die Umgebungstemperatur und die im Schaltgerät auftretenden Temperaturen mit der Zeit verändern. Z.B. können die Dämpfungselemente spröde werden und sich auflösen. Die Dämpfungswirkung ist ebenfalls von der Temperatur abhängig, da die Elastizität des Dämpfungsgummis temperaturabhängig ist.

Diese Nachteile sind mit der vorgeschlagenen Schaltungsanordnung nicht mehr gegeben, da die Energie gezielt aus dem Antrieb entzogen werden kann. "Gezielt" bedeutet in diesem Zusammenhang, dass die Energie durch das synchrone Schalten einerseits schnell genug aus dem Antrieb genommen wird, um die Verzugszeiten zu minimieren, und andererseits aber so langsam, dass die bewegliche Masse durch die im Antrieb noch verbliebene Energie gebremst wird. Somit wird nicht die gesamte potentielle Energie schlagartig abgegeben, sondern über die Zeit verteilt.

Gemäß einer zweckmäßigen Ausgestaltung ist im Lastpfad des zweiten Schaltelements eine mit der Auswerte- und Steuereinheit gekoppelte Strommesseinrichtung angeordnet, wobei im Betrieb der Schaltungsanordnung eine dem Strom durch den Lastpfad entsprechende Information zur Ansteuerung des zweiten Schaltelements verarbeitet wird.

Zweckmäßigerweise wird das zweite Schaltelement beim Ausschalten durch die Auswerte- und Ansteuereinheit derart geschaltet, dass ein beim Ausschalten der Last entstehender Stromimpuls nicht höher als maximal 2/3 eines mittleren Anzugstromwertes der Last ist. Hierdurch wird die Höhe der Stromspitze auf einen gewünschten, der Masse angepassten Wert begrenzt.

Gemäß einer weiteren zweckmäßigen Ausgestaltung ist das Begrenzungselement ein Varistor oder eine Z-Diode. Diese ermöglichen durch an die Last (d.h. an das Schaltgerät angepasste Masse) angepasste Dimensionierung den ausreichend schnellen Abbau von Energie.

Die galvanisch getrennte Ansteuerung kann z.B. einen Optokoppler umfassen. Die galvanisch getrennte Ansteuerung ist mit einem Steuereingang des ersten Schaltelements verbunden.

Gemäß einer weiteren zweckmäßigen Ausgestaltung ist für die Ermittlung der Höhe der Steuerspeisespannung ein Spannungsteiler, der zwei in Reihe verschaltete Widerstände umfasst, vorgesehen.

Die Erfindung schlägt ferner ein Verfahren zum Betreiben einer Schaltungsanordnung zum Abbauen von durch eine induktive Last verursachten Abschaltüberspannungen beim Abschalten der induktiven Last vor, wobei die Schaltungsanordnung gemäß der vorstehenden Beschreibung ausgebildet ist. Bei diesem Verfahren wird ein im Lastpfad des zweiten Schaltelements fließender Strom durch die Auswerte- und Steuereinheit gemessen und eine dem Strom durch den Lastpfad entsprechende Information zur Ansteuerung des zweiten Schaltelements verarbeitet.

Das zweite Schaltelement wird gemäß einer Ausgestaltung beim Ausschalten durch die Auswerte- und Ansteuereinheit derart geschaltet, dass ein beim Ausschalten der Last entstehender Stromimpuls nicht höher als maximal 2/3 eines mittleren Anzugstromwertes der Last ist.

Die Erfindung ermöglicht im Ergebnis eine elektronische, temperaturunabhängige Dämpfung beim Schalten einer induktiven Last, die durch die synchrone Ansteuerung von Last und Freilaufkreis sowie die Dimensionierung der in der Schaltungsanordnung eingesetzten Bauelemente sowohl für kleine, aber insbesondere für große Schaltgeräte zum Einsatz kommen kann. Durch die Dämpfung wird ein sanftes Öffnen des Schaltgeräts bewirkt, welches einen starken Ausschaltrückprall verhindert und ein komplexes Dämpfungssystem aus Gummis, Federn oder Stoßdämpfern entbehrlich macht. Die Ausschaltdämpfung ist dabei für Niederspannungsschaltgeräte temperaturunabhängig.

Die Dimensionierung der Bauelemente, insbesondere des Begrenzungselements, bemisst sich nach der sich bewegenden Masse des Schaltgeräts, der Kraft der Rückdruckfedern im Schaltgerät, der zum Zeitpunkt des Ausschaltens im Antrieb des Schaltgeräts gespeicherten Energie, dem Abstand der Kontakte im geöffneten Zustand zu einer Kontaktbrücke sowie dem Abstand der Kontakte zum Gehäuse des Schaltgeräts. Da es keine exakte Formel zur Berechnung des idealen Begrenzungselementes gibt, wird dessen Wert z.B. empirisch ermittelt.

Die Erfindung wird nachfolgend näher anhand eines Ausführungsbeispiels erläutert. Es zeigen:
- Fig. 1: eine erfindungsgemäße Schaltungsanordnung zum Abbauen von durch eine induktive Last verursachten Abschaltüberspannungen beim Abschalten der induktiven Last;
- Fig. 2: ein Diagramm, das die Ausschaltdämpfung eines großen Schaltgeräts ohne Begrenzungselement zeigt;
- Fig. 3: ein Diagramm, das die Ausschaltdämpfung eines großen Schaltgeräts mit einem zu groß dimensionierten Begrenzungselement zeigt; und
- Fig. 4: ein Diagramm, das die Ausschaltdämpfung eines großen Schaltgeräts mit einem optimiert dimensionierten Begrenzungselement zeigt.

In der vorliegenden Beschreibung wird unter einem großen Schaltgerät ein Schaltgerät verstanden, das Leistungen von mehr als 55kW, insbesondere von mehr als 500kW, schaltet.

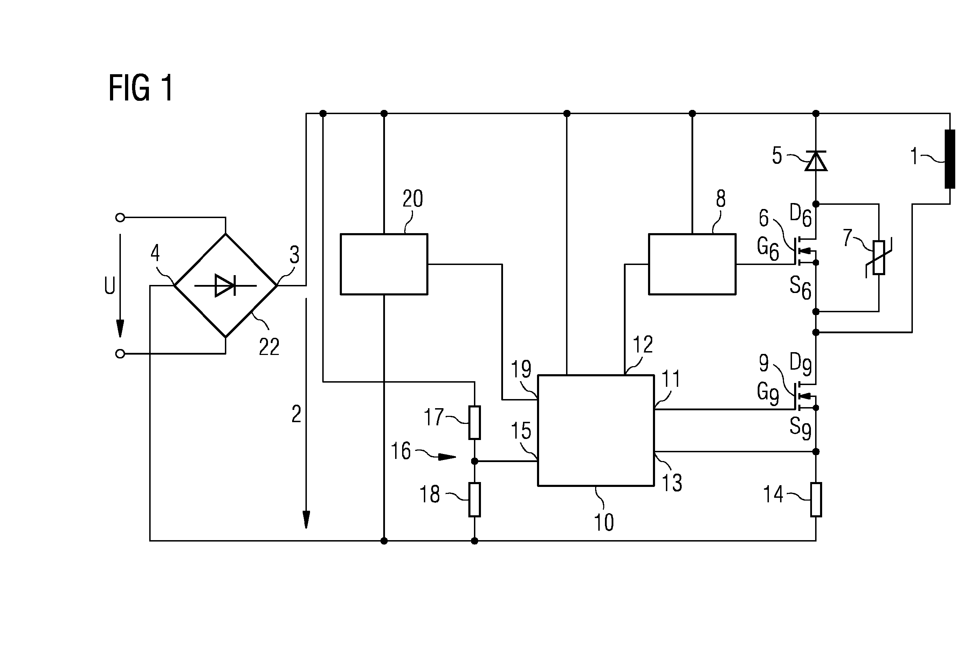

Fig. 1 zeigt eine erfindungsgemäße Schaltungsanordnung zum Abbauen von durch eine induktive Last 1 verursachten Abschaltüberspannungen beim Abschalten der induktiven Last 1. Die induktive Last 1 ist z.B. eine Spule eines elektromechanischen Schaltgeräts, zum Beispiel eines Schützes. Der induktiven Last 1 ist ein Freilaufkreis parallel geschaltet. Der Freilaufkreis besteht aus einer Freilaufdiode 5, einem steuerbaren Schaltelement 6 und einem dem steuerbaren Schaltelement 6 parallel geschalteten Begrenzungselement 7. Die Reihenschaltung aus der Freilaufdiode 5 und dem steuerbaren Schaltelement 6 ist der Spule 1 parallel geschaltet. Die Spule 1 kann auch als Teil des Freilaufkreises angesehen werden. Das Schaltelement 6 wird auch als Freilauftransistor bezeichnet. Das Schaltelement 6 kann z.B. als MOSFET oder als IGBT ausgeführt sein. Das Begrenzungselement 7, beispielsweise ein Varistor oder eine Z-Diode, ist, wie aus der nachfolgenden Beschreibung deutlich werden wird, hinsichtlich seiner Dimensionierung auf den elektromagnetischen Antrieb des Schaltgeräts abgestimmt.

Mit dem Knotenpunkt der Spule 1 und des Schaltelements 6 ist ein Schaltelement 9 verbunden, das dazu dient, den elektromagnetischen Antrieb ein- und auszuschalten, indem ein Stromfluss durch die Spule 1 ermöglicht wird oder nicht. Während der Drain-Anschluss D₉ mit dem eben erwähnten Knotenpunkt von Spule 1 und Schaltelement 6 verbunden ist, ist der Source-Anschluss S₉ des Schaltelements 9 mit einem Shunt 14 verbunden. Der Knotenpunkt zwischen dem Schaltelement 9 und dem Shunt 14 ist mit einer Auswerte- und Ansteuereinheit 10 gekoppelt. Über den Shunt 14 wird der Strom im Lastpfad des Schaltelements 9 bei eingeschaltetem, elektromagnetischen Antrieb 1 und beim Ausschalten durch die Auswerte- und Ansteuereinheit 10 gemessen. Hierzu ist der Knotenpunkt zwischen dem Schaltelement 9 und dem Shunt 14 mit einem Eingang 13 der Auswerte-und Ansteuereinheit 10 verbunden.

Die induktive Last 1 wird durch eine Steuerspeisespannung 2, welche zwischen Anschlüssen 3 und 4 eines Gleichrichters 22 anliegt, versorgt. Die anderen Anschlüsse des Gleichrichters 22 werden in diesem Ausführungsbeispiel von einer Steuerspannung U beaufschlagt. Es versteht sich, dass die Steuerspannung auch direkt als Gleichspannung bereitgestellt werden kann, so dass diese die Steuerspeisespannung 2 darstellt.

Die Versorgungsspannung für die Auswerte- und Ansteuereinheit 10 wird durch eine Spannungsversorgungseinheit 20 aus der Steuerspeisespannung 2 gewonnen, wobei die Spannungsversorgungseinheit zwischen den Anschlüssen 3 und 4 des Gleichrichters 22 verschaltet ist. Die von der Spannungsversorgungseinheit 20 bereitgestellte Versorgungsspannung wird der Auswerte- und Ansteuereinheit an einem Eingang 19 bereitgestellt. Ferner ist zwischen den Anschlüssen 3 und 4 des Gleichrichters 22 ein Spannungsteiler 16, der aus zwei seriell miteinander verschalteten Widerständen 17, 18 besteht, verschaltet. Ein Knotenpunkt des Spannungsteilers 16 ist mit einem Eingang 15 der Auswerte- und Ansteuereinheit 10 verbunden. Mithilfe des an dem Knotenpunkt des Spannungsteilers 16 anliegenden Spannungssignals wertet die Auswerte- und Ansteuereinheit 10 eine vorgegebene Einschaltschwelle für das Einschalten des elektromagnetischen Antriebs und eine vorgegebene Ausschaltschwelle für das Ausschalten des elektromagnetischen Antriebs 1 aus. Die vorgegebene Einschaltschwelle und die vorgegebene Ausschaltschwelle können beispielsweise in einem nicht näher dargestellten Speicher der Auswerte- und Ansteuereinheit 10 hinterlegt sein.

Zum Ansteuern des Schaltelements 9 ist die Auswerte- und Ansteuereinheit 10 an einem Ausgang 11 mit einem Steueranschluss G₉ des Schaltelements 9 verbunden. Die Ansteuerung des Schaltelements 6 (Freilauftransistor) erfolgt über einen Ausgang 12. Der Ausgang 12 der Auswerte- und Ansteuereinheit 10 ist über eine galvanisch getrennte Ansteuerung 8 mit dem Steueranschluss G₆ verbunden. Die galvanisch getrennte Ansteuerung 8 kann beispielsweise durch einen Optokoppler realisiert sein. Eine Spannungsversorgung der galvanisch getrennten Ansteuerung erfolgt durch eine Kopplung mit dem Anschluss 3 des Gleichrichters 22.

Sobald die an dem Knotenpunkt des Spannungsteilers 16 anliegende Spannung über der Einschaltschwelle liegt, so gibt die Ansteuer- und Auswerteeinheit 10 das Kommando zum Einschalten des Schaltelements 9 weiter. Das Schaltelement 9 wird hierdurch eingeschaltet (d.h. leitend geschaltet). Gleichzeitig wird das Schaltelement 6 über die galvanisch getrennte Ansteuerung 8 dauerhaft bis zu einem Aus-Kommando eingeschaltet (d.h. leitend geschaltet). Über den Shunt 14 wird nun der Strom zum Einschalten des elektromagnetischen Antriebs mittels des Schaltelements 9 konstant gehalten. Der durch den Lastpfad fließende und über den Shunt 14 ermittelte Strom wird somit zur Ansteuerung des Schaltelements 9 verwendet. Diese Vorgehensweise wird ebenso für den geschlossenen Zustand des elektromagnetischen Antriebs angewandt.

Soll der elektromagnetische Antrieb ausgeschaltet werden, so wird durch die an dem Spannungsteiler 16 anliegende Spannung die vorgegebene Ausschaltschwelle erkannt. Das Schaltelement 9 und das Schaltelement 6 werden durch die Ansteuer- und Auswerteeinheit 10 synchron ausgeschaltet. Durch das Ausschalten des Schaltelements 9 wird die Spule des elektromagnetischen Antriebs von der Steuerspeisespannung getrennt. Aufgrund der Induktivität der Spule 1 baut sich eine hohe Überspannung auf. Diese führt dazu, dass die Energie innerhalb der Spule über das Begrenzungselement 7 schlagartig abgebaut wird, da auch das Schaltelement 6 durch die galvanisch getrennte Ansteuerung im Freilaufkreis geöffnet ist. Der Energieabbau führt dazu, dass ein Stromimpuls, dessen Höhe abhängig von der Dimensionierung des begrenze Bausteins ist, erzeugt wird. Durch die Dimensionierung des Begrenzungselements 7 kann der Stromimpuls auf maximal 2/3 des mittleren Anzugstromwertes des elektromagnetischen Antriebs begrenzt werden. Dieser Stromimpuls hat eine bremsende Wirkung auf das sich öffnende Magnetsystem, d.h. die bewegte Masse des elektromagnetischen Antriebs.

Bei der Dimensionierung des Begrenzungselements 7 der Schaltungsanordnung sind mehrere Faktoren zu berücksichtigen. Zum einen sind dies die sich bewegende Masse in dem elektromagnetischen Antrieb, die Kraft der Rückdruckfedern in dem Antrieb sowie die zum Zeitpunkt des Ausschaltens des Antriebs im Antrieb gespeicherte Energie. Weitere Auslegungsparameter sind der Abstand der Kontakte im geöffneten Zustand zur so genannten Kontaktbrücke sowie der Abstand der Kontakte zum Gehäuse.

Um das Ausschalten des elektromagnetischen Antriebs mit dem Aktivieren des Freilaufkreises zu synchronisieren, erfolgt die Ansteuerung des Schaltelements 6 galvanisch getrennt, zum Beispiel mittels eines Optokopplers. Hierdurch ist sichergestellt, dass die in der Auswerte-und Ansteuereinheit 10 enthaltene Ausschaltschwelle eingehalten wird und sich die Anordnung bei Erreichen einer minimalen angelegten Spannung immer beim gleichen Wert abschaltet. Hierdurch kann dann auch die maximale Höhe der auftretenden Stromspitze, welche wie erläutert höchstens 2/3 des Anzugstromwertes betragen sollte, gewährleistet werden.

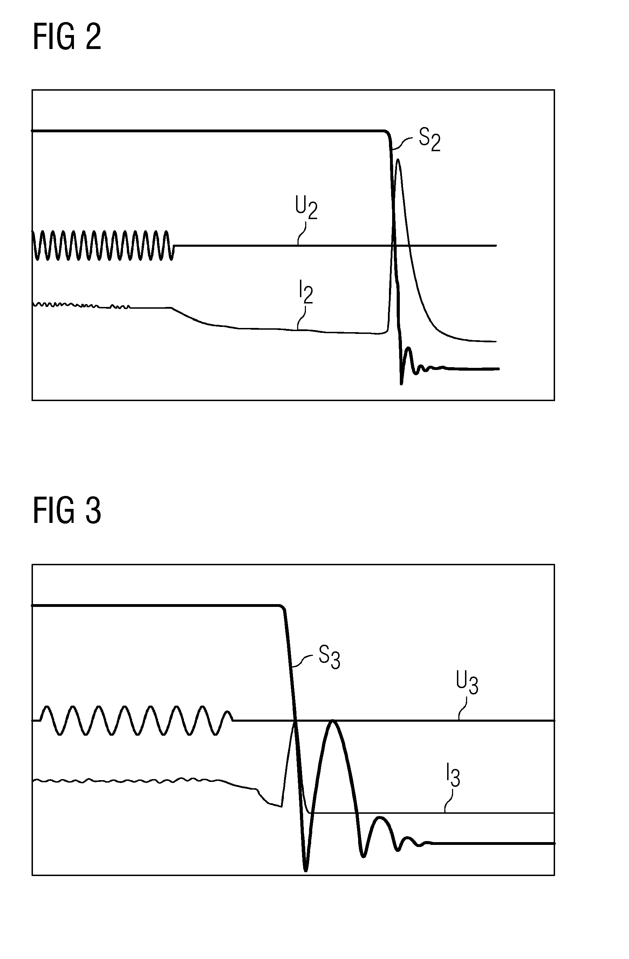

In der nachfolgenden Beschreibung werden unter Bezugnahme auf die Figuren 2 bis 4 Darstellungen erläutert, in denen die Wirkung auf den Rückprall der Kontakte eines großen elektromagnetischen Antriebs beim Ausschalten bei verschieden dimensionierten Begrenzungselementen 7 zu erkennen ist. Die Diagramme zeigen jeweils den Verlauf des Stromes I, der Spannung U und des Wegs s. Die jeweiligen Indizes beziehen sich auf die Nummer der Figur und damit die betreffende Dimensionierung des Begrenzungselements.

Fig. 2 zeigt den Verlauf von Spannung U₂, Strom I₂ und Weg S₂, wenn in der in Fig. 1 gezeigten Schaltungsanordnung kein Begrenzungselement im Freilaufkreis enthalten ist. Beim Ausschalten ohne Begrenzungselement ist der zurückgelegte Weg der Kontakte des elektromagnetischen Antriebs ideal. Die Stromspitze, die durch die Gegenspannung im Antrieb induziert wird, ist jedoch sehr hoch. Dadurch kann es im schlechtesten Fall zu einem ungewollten Schließen der Kontakte kommen. Dies bedeutet, der elektromagnetischen Antrieb schaltet sich kurzzeitig wieder ein. Darüber hinaus ist die Ausschaltzeit sehr hoch. In diesem Ausführungsbeispiel ergibt sich eine Ausschaltzeit von ca. 430 ms. Der Verzicht auf ein Begrenzungselement bringt ferner ein sehr geringes Prellen mit sich.

Fig. 3 zeigt den Verlauf von Spannung U₃, Strom I₃ und Weg S₃, wenn in der in Fig. 1 gezeigten Schaltungsanordnung ein zu großes Begrenzungselement im Freilaufkreis enthalten ist. Wird das Begrenzungselement wie bei kleinen Schaltgeräten mit einer sehr hohen Spannung gewählt, so ist die durch die Gegenspannung induzierte Stromspitze sehr niedrig. Die Gefahr eines ungewollten Kontaktschließens ist nicht vorhanden. Die Ausschaltzeiten sind sehr kurz. Nachteilig ist, dass es zu einem starken Rückprall kommt, bei dem die Gefahr besteht, dass entweder das Gehäuse des Antriebs beschädigt wird oder beim Zurückprallen der Kontakte vom Gehäuse noch so viel Bewegungsenergie vorhanden ist, dass es dabei zu einem ungewollten Schließen der Kontakte kommt. Ein zu großes Begrenzungselement führt damit zu einem starken Prellen. Dies kann zu einem Lichtbogen, Kontaktabbrand oder einer Gehäusebeschädigung führen. Bei einem zu großen Begrenzungselement ergibt sich eine sehr kurze Ausschaltzeit von ca. 50 ms.

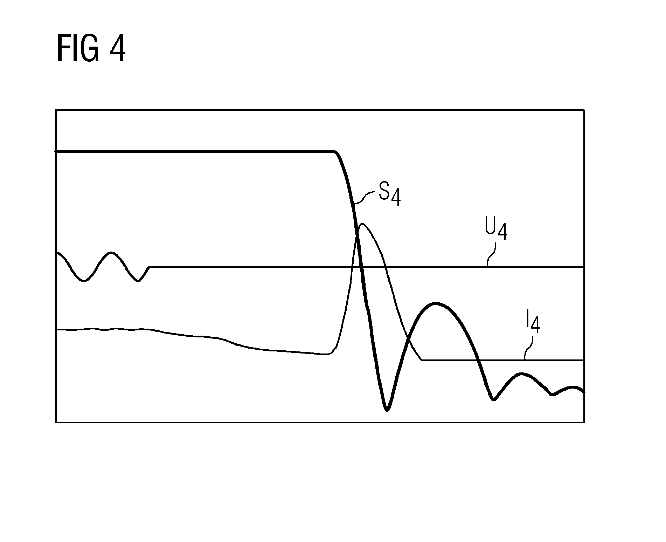

Fig. 4 zeigt den Verlauf von Spannung U₄, Strom I₄ und Weg S₄, wenn in der in Fig. 1 gezeigten Schaltungsanordnung ein optimal dimensioniertes Begrenzungselement im Freilaufkreis enthalten ist. Bei einem optimal dimensionierten Begrenzungselement wird die Stromspitze zum einen nicht zu hoch, idealerweise maximal ca. 2/3 des zum Einschalten notwendigen Stromes, und zum anderen die im Antrieb gespeicherte potentielle Energie so aus diesem entnommen, dass ein Rückprall nicht zu stark ausfällt. Bei einem optimierten Begrenzungselement ergibt sich eine mittlere Ausschaltzeit von ca. 80 ms. Das Diagramm zeigt ein mittleres Prellen, d.h. der Weg ist weder zu stark nach unten, was eine Gehäusebeschädigung nach sich ziehen könnte, noch zu sehr nach oben, was bei zu starker Annäherung der Kontakte zu einem Lichtbogen führen könnte.

## Patentansprüche

1. Schaltungsanordnung zum Bremsen einer sich bewegenden Masse beim Abschalten eines elektromechanischen Schaltgeräts mit einer induktiven Last (1), umfassend:
a) einen Freilaufkreis, der eine parallel zur Last (1) liegende Reihenschaltung aus einer ersten Diode (5) und einem Begrenzungselement (7) umfasst, wobei dem Begrenzungselement (7) ein erstes Schaltelement (6) parallel geschaltet ist,
b) ein zweites Schaltelement (9), das zum Ein- und Ausschalten der Last (1) in Reihe mit dem Freilaufkreis verschaltet ist, und
c) eine Ansteuerung,
**dadurch gekennzeichnet, dass**
die Ansteuerung eine Auswerte- und Steuereinheit (10) zur synchronen Ansteuerung des ersten und zweiten Schaltelements (6, 9) umfasst, wobei die Auswerte- und Steuereinheit (10) zur Ansteuerung des ersten Schaltelements (6) mit einer galvanisch getrennten Ansteuerung (8) des ersten Schaltelements (6) und zur Ansteuerung des zweiten Schaltelements (9) mit dessen Steuereingang (G) verbunden ist und die Ansteuerung des ersten und des zweiten Schaltelements in Abhängigkeit der Höhe einer messtechnisch ermittelten Steuerspeisespannung erfolgt.

2. Schaltungsanordnung nach Anspruch 1, **dadurch gekennzeichnet, dass** im Lastpfad des zweiten Schaltelements (9) eine mit der Auswerte- und Steuereinheit (10) gekoppelte Strommesseinrichtung angeordnet ist, wobei im Betrieb der Schaltungsanordnung eine dem Strom durch den Lastpfad entsprechende Information zur Ansteuerung des zweiten Schaltelements (9) verarbeitet wird.

3. Schaltungsanordnung nach Anspruch 2, **dadurch gekennzeichnet, dass** das zweite Schaltelement (9) beim Ausschalten durch die Auswerte- und Ansteuereinheit derart geschaltet wird, dass ein beim Ausschalten der Last entstehender Stromimpuls nicht höher als maximal 2/3 eines mittleren Anzugstromwertes der Last ist.

4. Schaltungsanordnung nach einem der vorhergehenden Ansprüche, **dadurch gekennzeichnet, dass** das Begrenzungselement (7) ein Varistor oder eine Z-Diode ist.

5. Schaltungsanordnung nach einem der vorhergehenden Ansprüche, **dadurch gekennzeichnet, dass** die galvanisch getrennte Ansteuerung (8) einen Optokoppler umfasst.

6. Schaltungsanordnung nach einem der vorhergehenden Ansprüche, **dadurch gekennzeichnet, dass** die galvanisch getrennte Ansteuerung (8) mit einem Steuereingang (GFT) des ersten Schaltelements (6) verbunden ist.

7. Schaltungsanordnung nach einem der vorhergehenden Ansprüche, **dadurch gekennzeichnet, dass** für die Ermittlung der Höhe der Steuerspeisespannung (2) ein Spannungsteiler (16), der zwei in Reihe verschaltete Widerstände (17, 18) umfasst, vorgesehen ist.

8. Schaltungsanordnung nach einem der vorhergehenden Ansprüche, **dadurch gekennzeichnet, dass** die induktive Last (1) eine Spule eines elektromechanischen Schaltgeräts ist.

9. Verfahren zum Betreiben einer Schaltungsanordnung zum Abbauen von durch eine induktive Last (1) verursachten Abschaltüberspannungen beim Abschalten der induktiven Last (1), wobei die Schaltungsanordnung gemäß einem der Ansprüche 1 bis 7 ausgebildet ist, bei dem ein im Lastpfad des zweiten Schaltelements (9) fließender Strom durch die Auswerte- und Steuereinheit (10) gemessen wird und eine dem Strom durch den Lastpfad entsprechende Information zur Ansteuerung des zweiten Schaltelements (9) verarbeitet wird.

10. Verfahren nach Anspruch 9, **dadurch gekennzeichnet, dass** das zweite Schaltelement (9) beim Ausschalten durch die Auswerte- und Ansteuereinheit derart geschaltet wird, dass ein beim Ausschalten der Last entstehender Stromimpuls nicht höher als maximal 2/3 eines mittleren Anzugstromwertes der Last ist.
